# EUROPEAN PATENT APPLICATION

(11) **EP 4 328 976 A1**
(43) Date of publication of application: **28.02.2024**
(21) Application number: 22204107.1
(22) Date of filing: 27.10.2022
(51) Int. Cl.: H01L 29/778, H01L 21/337, H01L 29/423, H01L 29/10, H01L 29/20

(54) **HIGH ELECTRON MOBILITY TRANSISTOR AND METHOD FOR FABRICATING THE SAME**

(30) Priority: 24.08.2022 TW 111131884
(71) Applicant: United Microelectronics Corp., Hsin-Chu City 300 (TW)
(72) Inventor: YEH, Chih-Tung, Taoyuan City 320 (TW); CHANG, You-Jia, Taoyuan City 324 (TW); CHEN, Bo-Yu, Toucheng Township, Yilan County 261 (TW); WANG, Yun-Chun, Chiayi City 600 (TW); LEE, Ruey-Chyr, Taichung City 406 (TW); LIAO, Wen-Jung, Hsinchu City 300 (TW)
(74) Representative: Isarpatent

(57) **Abstract**

A method for fabricating a high electron mobility transistor (HEMT) includes the steps of forming a buffer layer (14) on a substrate (12), forming a barrier layer (16) on the buffer layer, forming a p-type semiconductor layer (18) on the barrier layer, forming a gate electrode layer (26) on the p-type semiconductor layer, and patterning the gate electrode layer to form a gate electrode. The gate electrode includes an inclined sidewall.

## Description

### Background of the Invention

The invention relates to a high electron mobility transistor (HEMT) and a fabrication method thereof.

High electron mobility transistor (HEMT) fabricated from GaN-based materials have various advantages in electrical, mechanical, and chemical aspects of the field. For instance, advantages including wide band gap, high break down voltage, high electron mobility, high elastic modulus, high piezoelectric and piezoresistive coefficients, and chemical inertness. All of these advantages allow GaN-based materials to be used in numerous applications including high intensity light emitting diodes (LEDs), power switching devices, regulators, battery protectors, display panel drivers, and communication devices.

### Summary of the Invention

According to an embodiment of the present invention, a method for fabricating a high electron mobility transistor (HEMT) includes the steps of forming a buffer layer on a substrate, forming a barrier layer on the buffer layer, forming a p-type semiconductor layer on the barrier layer, forming a gate electrode layer on the p-type semiconductor layer, and patterning the gate electrode layer to form a gate electrode. Preferably, the gate electrode includes an inclined sidewall.

According to another aspect of the present invention, a high electron mobility transistor (HEMT) includes a buffer layer on a substrate, a barrier layer on the buffer layer, a p-type semiconductor layer on the barrier layer, and a gate electrode layer on the p-type semiconductor layer. Preferably, the gate electrode includes an inclined sidewall.

These and other objectives of the present invention will no doubt become obvious to those of ordinary skill in the art after reading the following detailed description of the preferred embodiment that is illustrated in the various figures and drawings.

### Brief Description of the Drawings

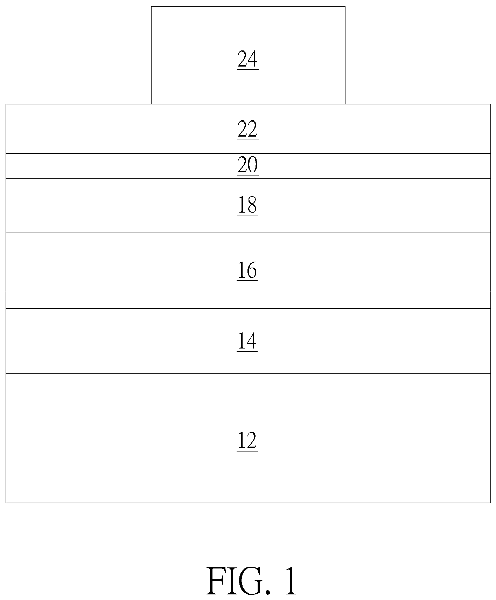

Figs. 1-4 illustrate a method for fabricating a HEMT according to an embodiment of the present invention.

### Detailed Description

Referring to Figs. 1-4, Figs. 1-4 illustrate a method for fabricating a HEMT according to an embodiment of the present invention. As shown in Fig. 1, a substrate 12 such as a substrate made from silicon, silicon carbide, or aluminum oxide (or also referred to as sapphire) is provided, in which the substrate 12 could be a single-layered substrate, a multi-layered substrate, gradient substrate, or combination thereof. According to other embodiment of the present invention, the substrate 12 could also include a silicon-on-insulator (SOI) substrate.

Next, a selective nucleation layer (not shown) and a buffer layer 14 are formed on the substrate 12. According to an embodiment of the present invention, the nucleation layer preferably includes aluminum nitride (AlN) and the buffer layer 14 is preferably made of III-V semiconductors such as gallium nitride (GaN), in which a thickness of the buffer layer 14 could be between 0.5 microns to 10 microns. According to an embodiment of the present invention, the formation of the buffer layer 14 on the substrate 12 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof.

Next, a selective unintentionally doped (UID) buffer layer (not shown) could be formed on the surface of the buffer layer 14. In this embodiment, the UID buffer layer is preferably made of III-V semiconductors such as gallium nitride (GaN) or more specifically unintentionally doped GaN. According to an embodiment of the present invention, the formation of the UID buffer layer on the buffer layer 14 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof.

Next, a barrier layer 16 is formed on the surface of the buffer layer 14 or UID buffer layer. In this embodiment, the barrier layer 16 is preferably made of III-V semiconductor such as n-type or n- graded aluminum gallium nitride (AlₓGa₁₋ₓN), in which 0<x<1, the barrier layer 16 preferably includes an epitaxial layer formed through epitaxial growth process, and the barrier layer 16 could include dopants such as silicon or germanium. Similar to the buffer layer 14, the formation of the barrier layer 16 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof.

Next, a p-type semiconductor layer 18, a gate electrode layer 20, a hard mask 22, and a patterned mask 24 such as patterned resist are formed sequentially on the barrier layer 16. In this embodiment, the p-type semiconductor layer 18 is a III-V compound semiconductor layer preferably including p-type GaN (pGaN) and the formation of the p-type semiconductor layer 18 on the barrier layer 16 could be accomplished by a molecular-beam epitaxy (MBE) process, a metal organic chemical vapor deposition (MOCVD) process, a chemical vapor deposition (CVD) process, a hydride vapor phase epitaxy (HVPE) process, or combination thereof.

In this embodiment, the gate electrode layer 20 is preferably made of Schottky metal, in which the gate electrode layer 20 could include gold (Au), silver (Ag), platinum (Pt), titanium (Ti), aluminium (Al), tungsten (W), palladium (Pd), or combination thereof. Preferably, it would be desirable to conduct an electroplating process, sputtering process, resistance heating evaporation process, electron beam evaporation process, physical vapor deposition (PVD) process, chemical vapor deposition (CVD) process, or combination thereof to form the above conductive materials on the p-type semiconductor layer 18 serving as the gate electrode layer 20. Moreover, the hard mask 22 could be made of dielectric material including but not limited to for example silicon nitride (SiN).

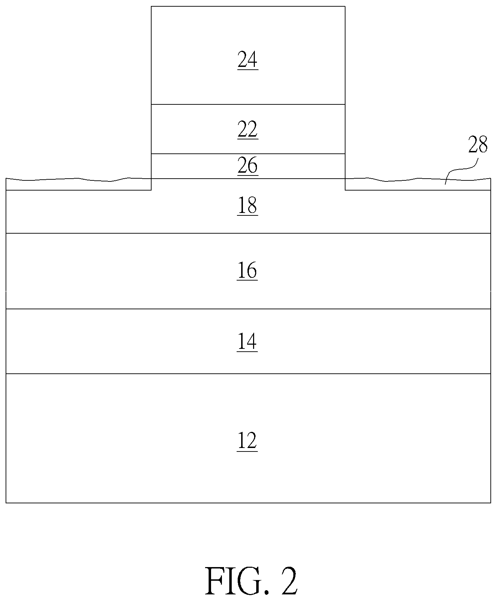

Referring to Figs. 2-4, Figs. 2-4 illustrate a method of using a photo-etching process to pattern the gate electrode layer 20 for forming a gate electrode 26 according to an embodiment of the present invention. As shown in Figs. 2-3, an etching process is first conducted by using the patterned mask 24 as mask to remove or pattern part of the hard mask 22 and part of the gate electrode layer 20 for forming a gate electrode 26. Preferably, the etching process conducted at this stage uses fluorine-containing gas or fluoride such as CF₄ or SF₆ to remove part of the hard mask 22 and part of the gate electrode layer 20. As part of the hard mask 22 and part of the gate electrode layer 20 are removed, the fluorine-containing gas preferably reacts with the p-type semiconductor layer 18 to form a byproduct 28 on the surface of the p-type semiconductor layer 18. Since the byproduct 28 is formed by reaction between the fluorine-containing gas and the p-type semiconductor layer 18, the main composition of the byproduct 28 preferably includes gallium (Ga).

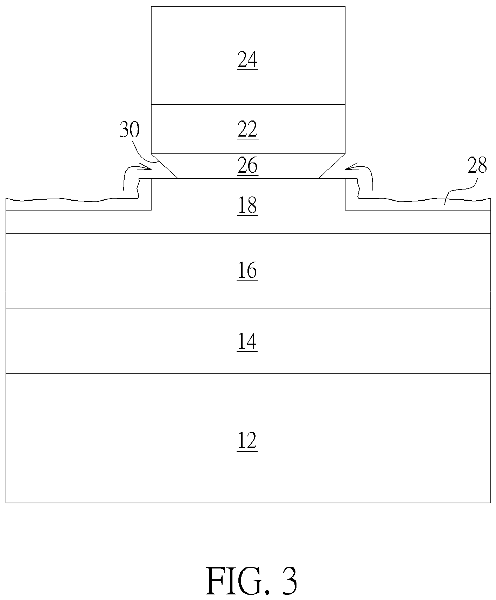

Next, as shown in Fig. 3, as the fluorine-containing gas continues to remove part of the p-type semiconductor layer 18 downward, the byproduct 28 would cover the top surface and sidewalls of the patterned p-type semiconductor layer 18 in particularly the top surface of the p-type semiconductor layer 18 adjacent to two sides of the gate electrode 26 and sidewalls of the p-type semiconductor layer 18 directly under the gate electrode 26. It should be noted that as the amount of the byproduct 28 increases, the byproduct 28 which was originally grown on sidewalls of the p-type semiconductor layer 18 directly under the gate electrode 26 would accumulate upward and slowly erode or eating away sidewalls of the gate electrode 26 along the direction of the arrow. This causes the sidewalls of the gate electrode 26 to retract inward and forms inclined sidewalls 30.

Structurally, the overall gate electrode 26 formed at this stage preferably includes a trapezoid shape or more specifically a reverse trapezoid cross-section, in which the bottom surface or bottom width of the gate electrode 26 is slightly less than the top surface or top width of the gate electrode 26. Moreover, the angle included between the inclined sidewall 30 and the top surface of the p-type semiconductor layer 18 could be between 30-70 degrees or most preferably between 40-46 degrees. It should also be noted that as the byproduct 28 erodes away sidewalls of the gate electrode 26 to form inclined sidewalls 30, the byproduct 28 which was accumulated on sidewalls of the gate electrode 26 would be consumed at the same time after the inclined sidewalls 30 are formed. In other word, after the byproduct 28 erodes away the gate electrode 26 to form inclined sidewalls 30 no byproduct 28 is remained on sidewalls of the gate electrode 26.

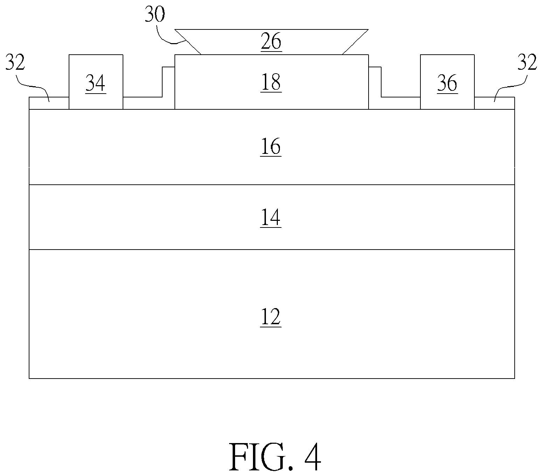

Next, as shown in Fig. 4, after the aforementioned fluorine-containing gas patterns the p-type semiconductor layer 18 completely and exposes the surface of the barrier layer 16 on two adjacent sides, another etching process could be conducted to remove any remaining byproduct 28, the patterned mask 24, and the hard mask 22 to expose the top surface of the gate electrode 26. Next, a selective passivation layer 32 could be formed on the barrier layer 16, part of the passivation layer 32 adjacent to two sides of the gate electrode 26 could be removed to form two openings (not shown), and a source electrode 34 and drain electrode 36 could be formed in the openings adjacent to two sides of the gate electrode 26.

Even though the passivation layer 32 in this embodiment pertains to be a single-layered structure, according to other embodiment of the present invention, it would also be desirable to form a passivation layer 32 made from a dual layer or tri-layer structure, in which the passivation layer 32 could be made of dielectric material including but not limited to for example silicon oxide, silicon nitride, or aluminium oxide.

Moreover, the source electrode 34 and the drain electrode 36 are preferably made of metal. In contrast to the gate electrode 26 is preferably made of Schottky metal, the source electrode 34 and the drain electrode 36 are preferably made of ohmic contact metals. According to an embodiment of the present invention, each of the gate electrode 26, source electrode 34, and drain electrode 36 could include gold (Au), silver (Ag), platinum (Pt), titanium (Ti), aluminium (Al), tungsten (W), palladium (Pd), or combination thereof. Preferably, it would be desirable to conduct an electroplating process, sputtering process, resistance heating evaporation process, electron beam evaporation process, physical vapor deposition (PVD) process, chemical vapor deposition (CVD) process, or combination thereof to form electrode materials in the aforementioned openings, and then pattern the electrode materials through one or more etching processes to form the source electrode 34 and the drain electrode 36. This completes the fabrication of a HEMT according to an embodiment of the present invention.

Typically, issue such as potential difference is often generated between Schottky metal of the gate electrode and p-type semiconductor layer under operation of high forward gate bias in current HEMTs and fringing field effect would also appear on sidewalls of the p-type semiconductor layer to cause reverse channel and results in current leakage. To resolve this issue, the present invention uses a fluorine-containing gas to pattern the gate electrode and p-type semiconductor layer, which principally utilizes the byproduct accumulated on sidewalls of the p-type semiconductor layer to slowly erode away part of the gate electrode for forming inclined sidewalls. According to a preferred embodiment of the present invention, the means of trimming sidewall of the gate electrode to form reverse trapezoid shape could effectively prevent current leakage on sidewalls of the gate electrode thereby improving issue such as high temperature gate bias.

## Claims

1. A method for fabricating a high electron mobility transistor, HEMT, comprising:
forming a buffer layer (14) on a substrate (12);
forming a barrier layer (16) on the buffer layer (14);
forming a p-type semiconductor layer (18) on the barrier layer (16);
forming a gate electrode layer (20) on the p-type semiconductor layer (18); and
patterning the gate electrode layer (20) to form a gate electrode (26), wherein the gate electrode (26) comprises an inclined sidewall (30).

2. The method of claim 1, further comprising:
performing an etching process to remove part of the gate electrode layer (20) for forming a byproduct (28) on a surface of the p-type semiconductor layer (18) and forming the inclined sidewall (30);
removing the byproduct (28); and
forming a source electrode (34) and a drain electrode (36) adjacent to two sides of the gate electrode (26).

3. The method of claim 2, wherein the etching process comprises fluoride.

4. The method of one of the claims 1 to 3, wherein the gate electrode (26) comprises a trapezoid.

5. The method of one of the claims 1 to 4, wherein a bottom surface of the gate electrode (26) is less than a top surface of the gate electrode (26).

6. The method of one of the claims 1 to 5, wherein the buffer layer (14) comprises gallium nitride, GaN.

7. The method of one of the claims 1 to 6, wherein the barrier layer (16) comprises AlₓGa₁-ₓN.

8. The method of one of the claims 1 to 7, wherein the p-type semiconductor layer (18) comprises p-type gallium nitride, pGaN.

9. A high electron mobility transistor, HEMT, comprising:
a buffer layer (14) on a substrate (12);
a barrier layer (16) on the buffer layer (14);
a p-type semiconductor layer (18) on the barrier layer (16); and
a gate electrode layer (20) forming a gate electrode (26) on the p-type semiconductor layer (18), wherein the gate electrode (26) comprises an inclined sidewall (30).

10. The HEMT of claim 9, wherein the gate electrode (26) comprises a trapezoid.

11. The HEMT of claim 9 or 10, wherein a bottom surface of the gate electrode (26) is less than a top surface of the gate electrode (26).

12. The HEMT of one of the claims 9 to 11, wherein the buffer layer (14) comprises gallium nitride, GaN.

13. The HEMT of one of the claims 9 to 12, wherein the barrier layer (16) comprises AlₓGa₁₋ₓN.

14. The HEMT of one of the claims 9 to 13, wherein the p-type semiconductor layer (18) comprises p-type gallium nitride, pGaN.
